# EUROPÄISCHE PATENTSCHRIFT

(11) **EP 3 864 709 B1**
(45) Veröffentlichungstag und Bekanntmachung des Hinweises auf die Patenterteilung: **06.09.2023**
(21) Anmeldenummer: 19789619.4
(22) Anmeldetag: 10.10.2019
(51) Int. Cl.: H01L 33/62, H01L 33/60

(54) **VERFAHREN ZUM HERSTELLEN EINER LICHTEMITTIERENDEN VORRICHTUNG**
METHOD FOR MANUFACTURING A LIGHT-EMITTING DEVICE
PROCÉDÉ DE FABRICATION D'UN DISPOSITIF D'ÉMISSION DE LUMIÈRE

(30) Priorität: 12.10.2018 DE 102018217469; 12.10.2018 DE 102018217465
(43) Veröffentlichungstag der Anmeldung: 18.08.2021
(73) Patentinhaber: OSRAM GmbH, 80807 München (DE)
(72) Erfinder: GROSSO, Davide, 31050 Ponzano Veneto (IT); RIEGER, Thomas, 93089 Aufhausen (DE); LAYER, Hans, 89075 Ulm (DE)
(74) Vertreter: SJW Patentanwälte
(86) Internationale Anmeldenummer: PCT/EP2019/077509
(87) Internationale Veröffentlichungsnummer: WO 2020/074654

(56) Entgegenhaltungen:
- WO-A1-2017/223255
- CN-A- 102 823 084
- US-A1- 2016 111 401

## Beschreibung

In verschiedenen Ausführungsformen wird ein Verfahren zum Herstellen einer lichtemittierenden Vorrichtung bereitgestellt.

In der Beleuchtungsindustrie werden lichtemittierende Vorrichtungen ausgebildet, indem lichtemittierende Halbleiterbauelemente auf Leiterplatten angeordnet werden. Die Leiterplatten werden dabei zur Bestromung der lichtemittierenden Halbleiterbauelemente verwendet. Die Leiterplatten sind flexible Leiterplatten (flexPBC oder FPC) oder rigide Leiterplatten (PCB) und weisen Schaltungen aus Kupfer-Leiterbahnen auf. Auf den Kupfer-Leiterbahnen wird eine polymere Maske aufgebracht, die Kontaktpads definiert und lateral um die Kontaktpads als Lötstopp wirkt.

Das lichtemittierende Bauelement wird mittels einer Lot-Legierung mit Kontaktpads verbunden. Die polymere Maske verhindert dabei ein unkontrolliertes Verlaufen der aufgeschmolzenen Lot-Legierung auf der Kupfer-Oberfläche der Leiterbahnen. Mit anderen Worten: die polymere Maske verhindert ein Abfließen eines Lots von den Bereichen, d.h. den Kontaktpads, in denen es benötigt wird, um eine gute Lötverbindung zwischen dem lichtemittierenden Bauelement und dem Kontaktpad zu gewährleisten.

Mittels der Lötverbindung kann eine genaue Platzierung des lichtemittierenden Bauelementes auf der Leiterplatte sichergestellt werden. Eine hoch reflektierende polymere Maske ermöglicht es, die Lichtausbeute der lichtemittierenden Vorrichtung zu erhöhen. Die Lichtausbeute hängt jedoch noch von der Bauart des lichtemittierenden Halbleiterbauelements ab, beispielsweise dem Typ einer Leuchtdiode, dem Layout der lichtemittierenden Vorrichtung usw..

Das Aufbringen und Aushärten der herkömmlichen polymeren Maske und deren Materialkosten sind recht kostenintensiv, da eine relativ dicke Schicht selektiv in vorgegebenen Bereichen mittels eines langsamen Siebdruckverfahrens oder eines langsamen Belichtungs- und Entwicklungsprozesses einer Maske (LPI-Verfahren) aufgebracht wird.

Das Aushärten einer polymeren Maske ist zudem ein langsamer Prozess und erfordert lange Öfen, insbesondere in Rolle-zu-Rolle-Herstellungsverfahren.

Bei Siebdruckverfahren besteht zudem das Problem, dass beim Bedrucken von Folien auf Rollen, die Siebdruckmaske mehrfach entlang der Rolle angeordnet wird und somit nebeneinander mehrere gedruckte Strukturen gebildet werden. Zwischen den gedruckten Strukturen entstehen dabei Lücken. Zum Schließen dieser Lücken ist es erforderlich, die Rolle zwei Mal durch die Druckvorrichtung zu führen.

Um flexible gedruckte Leiterplatten (engl. flexbile printed circuit, FPC) herzustellen, wird herkömmlich ein subattraktives Verfahren verwendet, bei dem eine Metallfolie vollflächig auf ein flexibles Substrat, beispielsweise eine Kunststofffolie aus PET, PEN oder PI, auflaminiert wird. Anschließend werden Teile der Metallfolie chemisch geätzt, um eine vorgegebene elektrische Schaltung zu erhalten.

Anschaulich wird beim subattraktiven Verfahren überall dort Metall der Metallfolie entfernt, wo für die Schaltung kein Metall erforderlich ist.

Die Metallfolie kann beispielsweise eine Kupferfolie oder eine Aluminiumfolie sein und die elektrische Schaltung weist beispielsweise Kupferleitungen und Lötpads auf.

Das Auflaminieren der Metallfolie auf das flexible Substrat erfolgt herkömmlich mit oder ohne Klebstoff.

Beim Prozess wird zunächst eine fotosensitive Schicht auf der Metallfolie aufgebracht und belichtet und anschließend wird eine nicht-aktive Schicht chemisch abgewaschen und anschließend wird das Metall der Metallfolie chemisch geätzt. Das chemische Ätzen der Metallfolie erfordert einen umfangreichen Einsatz chemischer Mittel und Wasser zum Spülen, das nachfolgend unter großem Aufwand entsorgt wird. Der Ätz-Prozess umfasst zudem eine Vielzahl an Prozessschritten, welche die Prozesskette verlängern, was negativen Einfluss auf die Herstellungszeit und Herstellungskosten hat. Einige dieser Prozessschritte bedeuten thermo-mechanisch Stress für die Kunststofffolie. Es ist daher erforderlich diesen in die Betrachtungen des Schaltung-Designs und in der jeweiligen Evaluierung des Schaltung Designs zu berücksichtigen, insbesondere wenn thermosensitive Materialien verwendet werden. Aktuelle Belichtungsprozesse erfordern zudem, dass die Folie getaktet wird und alle "x" mm zum Stillstand kommt und die Folie für die Belichtungszeit ruht. Dadurch erhöhen sich die Prozesszeiten, wodurch der Yield reduziert wird. Durch die oben genannten Aspekte erhöhen sich die Kosten für die Herstellung flexibler gedruckter Leiterplatten (FPC).

Zudem erscheint der Ätz-Prozess konträr zu einigen sich entwickelnden Trends, wie beispielsweise umweltverträgliche (grüne) Technologien, zunehmende Kosten für chemische Mittel und Prozesswasser-Entsorgung, zunehmende Kosten einiger Rohmaterialien und/oder einer schlanken Produktionskette. US 2016/111401 A1, CN 102 823 084 A, und WO 2017/223255 A1 beziehen sich auf ein Herstellungsverfahren für eine lichtemittierende Vorrichtung.

In verschiedenen Ausführungsformen wird ein Verfahren zum Herstellen einer Vorrichtung mit mindestens einem lichtemittierenden Bauelement bereitgestellt, mit dem es möglich ist, eines oder mehrere der oben genannten Probleme zu reduzieren oder zu beheben. Beispielsweise kann dadurch eine Vorrichtung mit mindestens einem lichtemittierenden Bauelement auf einem rigiden oder flexiblen Substrat effektiver, kostengünstiger und/oder umweltfreundlicher als bisher bereitgestellt werden.

Die Aufgabe wird gemäß einem Aspekt der Erfindung gelöst durch ein Verfahren zum Herstellen einer lichtemittierenden Vorrichtung, gemäß Anspruch 1. Das Verfahren weist auf: ein Ausbilden eines Trägers mit mindestens einer Leiterbahn auf einer Oberfläche des Trägers; ein Ausbilden einer reflektierenden Beschichtung direkt auf der mindestens einen Leiterbahn mittels eines Folientransfer-Verfahrens derart, dass die Leiterbahn im Wesentlichen von der reflektierenden Beschichtung bedeckt ist; und ein Anordnen eines lichtemittierenden Bauelementes auf oder über der reflektierenden Beschichtung, wobei das lichtemittierende Bauelement elektrisch leitend mit der mindestens einen Leiterbahn verbunden wird, wobei auf der Oberfläche des Trägers ferner mindestens ein Kontaktpad ausgebildet ist, das elektrisch leitend mit der mindestens einen Leiterbahn verbunden ist, und wobei die reflektierende Beschichtung derart auf oder über dem Kontaktpad ausgebildet wird, dass mindestens ein Teil des Kontaktpads freiliegt.

Die reflektierende Beschichtung soll die Leiterbahn im Wesentlichen bedecken, beispielsweise bist auf Kontakt- oder Anschlussbereiche, beispielsweise freiliegende Teile von Kontaktpads.

Mit anderen Worten: die reflektierende Beschichtung ist eine feste Struktur, die mittels eines Folientransfer-Verfahrens ausgebildet wird. Das Folientransfer-Verfahren kann ein heißes oder kaltes Folientransfer-Verfahren sein, wie es beispielsweise in der Verpackungsindustrie verwendet wird.

Die reflektierende Beschichtung kann aus einem hochreflektierenden Material gebildet werden. Beispielsweise wird die reflektierende Beschichtung aus einem Materialgemisch aus weißen, anorganischen Partikeln, beispielsweise aus TiO2, eingebettet in einer Polymer-Matrix, beispielsweise einem Harz, gebildet. Alternativ wird die lichtemittierende Struktur mittels Folientransfers mit metallischen Partikeln, beispielsweise aus Aluminium oder Chrom, die mittels physikalischer Gasphasenabscheidung beschichtet sind, ausgebildet, um selektiv die mindestens eine Leiterbahn zu bedecken. Die so ausgebildete lichtemittierende Struktur weist eine höhere Adhäsion zum Träger und zur Leiterbahn auf als bei einem herkömmlichen Verfahren.

Zudem können somit Bereiche, die frei von reflektierender Beschichtung bleiben sollen, beispielsweise Kontaktpads, auf einfache Weise frei gelassen werden.

Mittels des Folientransfer-Verfahrens kann zudem eine hoch reflektierende und/oder hoch flammenbeständige reflektierende Beschichtung ausgebildet werden. Eine derart ausgebildete, reflektierende Beschichtung kann die Entflammbarkeit des Trägers kompensieren, um eine Flammenbeständigkeitsanforderung von Beleuchtungsanwendungen zu erfüllen. Zudem ist mittels des Verfahrens möglich, eine mehrschichtige reflektierende Beschichtung auszubilden. Dies ermöglicht, die Reflektivität der reflektierenden Beschichtung auf das lichtemittierende Bauelement optimal einzustellen. Zudem kann dadurch die Flammbeständigkeit der lichtemittierenden Vorrichtung verbessert werden. Dabei bestehen weniger Verfahrensbeschränkungen im Vergleich zu herkömmlichen polymeren (Löt-)Masken, da sie nicht in jedem Fall mit der erforderlichen Dicke ausgebildet werden können.

Das Folientransfer-Verfahren ermöglicht zudem eine viel dünnere reflektierende Beschichtung bzw. lateral strukturierte Beschichtung als bei einer herkömmlich hergestellten polymeren (Löt-)Maske. Dadurch ist weniger Material erforderlich und die lichtemittierende Vorrichtung wird insgesamt dünner ausbildbar. Dies bewirkt, dass das Gewicht der lichtemittierenden Vorrichtung reduziert, die mechanische Flexibilität verbessert werden kann. Das Folientransfer-Verfahren ist ein sehr schnelles Verfahren und ermöglicht zudem eine Rolle-zu-Rolle-Verarbeitung mit hoher Geschwindigkeit. Im Vergleich dazu erfolgt ein Siebdruck einer herkömmlichen, polymeren Maske schrittweise und weist eine nur geringe Produktivität auf. Zudem kann mittels des Folientransfer-Verfahrens die reflektierende Beschichtung, beispielsweise mit einer Dicke von 5 µm, auf einfachere Weise und mit höherer Geschwindigkeit, mit geringerer Materialdicke und somit geringerem Volumen ausgebildet werden im Vergleich zu einer herkömmlichen, polymeren (Löt-)Maske.

Der Träger mit mindestens einer Leiterbahn kann eine flexible gedruckte Leiterplatte (flexPCB oder FPC) oder eine rigide gedruckte Leiterplatte (PCB) sein. Die mindestens eine Leiterbahn kann aus Kupfer oder einem anderen Material gebildet sein. Der Träger kann beispielsweise aus einem Polymer gebildet sein, beispielsweise PET, PEN, PI; oder CEM oder FR4, wie unten noch ausführlicher beschrieben wird.

Die mittels des Verfahrens hergestellte reflektierende Beschichtung kann sehr klare und besser definiertere Kanten aufweisen als eine herkömmlich hergestellte polymere Maske, die zudem eine sehr viel größere dicke aufweist.

Mittels des Verfahrens können zudem einfachere und hocheffizient verarbeitbare Materialien verwendet werden. Aufgrund einer kurzen, notwendigen Aushärtungszeit oder gar keiner Aushärtung, kann ein höherer Durchsatz in Rolle-zu-Rolle- Anwendungen oder in Folienstück-Anwendungen ermöglicht werden.

Zudem ist es mittels des Folientransfer-Verfahrens möglich, die reflektierende Beschichtung aus einem Metall auszubilden. Dies ist mit einem herkömmlichen Siebdruckverfahren nicht möglich. Das Metall kann eine höhere Reflektivität aufweisen als eine herkömmlich ausgebildete, polymere Maske. Für die reflektierende Beschichtung können zudem Metall mit speziellen Reflexionsverhalten verwendet werden, beispielsweise einem nicht-linearen Reflexionsgrad, beispielsweise einem Gold-Effekt, einer Rot-Verschiebung oder einer Blau-Verschiebung.

Zudem wird, verglichen mit dem Verlaufen abgeschiedener Tinte beim Herstellen einer herkömmlichen polymeren Maske, verhindert, dass aufgebrachte laterale Strukturierung verlaufen kann. Eine derart verlaufende Tinte könnte verschiedene Defekte bei der flexiblen gedruckten Leiterplatte bewirken, was mit dem Verfahren gemäß verschiedenen Ausführungsbeispielen verhindert wird.

Zudem wird kein wesentlicher thermischer Stress bzw. keine wesentliche thermische Verspannung auf die flexible gedruckte Leiterplatte ausgeübt, die andernfalls durch einen lang dauernden Aushärtungsprozess bei einem thermisch empfindlichen Träger auftreten würde, beispielsweise bei einem PET-Träger. Dies ermöglicht eine Erhöhung der Gestaltungsfreiheit bei der lichtemittierenden Vorrichtung. Zudem kann die Farbe der reflektierenden Beschichtung nahezu beliebig eingestellt werden, wodurch die Gestaltungsfreiheit weiterhin vergrößert wird

Zudem sind kostengünstigere und weniger Raum-einnehmende Ausrüstungen zum Ausbilden der Vorrichtung ermöglicht.

Die lichtemittierende Vorrichtung kann ohne herkömmlich verwendete, UV-aushärtende Klebstoffe ausgebildet werden. Dies ermöglicht eine UV-stabilere lichtemittierende Vorrichtung.

Ausführungsbeispiele der Erfindung sind in den Figuren dargestellt und werden im Folgenden näher erläutert.

Es zeigen
- Figur 1: schematische Querschnittsansichten zum Verfahren zum Herstellen einer Vorrichtung mit mindestens einem lichtemittierenden Bauelement gemäß verschiedenen Ausführungsformen;
- Figur 2: schematische Aufsichten zum Verfahren zum Herstellen einer Vorrichtung mit mindestens einem lichtemittierenden Bauelement gemäß verschiedenen Ausführungsformen;
- Figur 3: eine schematische Querschnittsansicht zum Verfahren zum Herstellen einer Vorrichtung mit mindestens einem lichtemittierenden Bauelement gemäß verschiedenen Ausführungsformen;
- Figur 4: schematische Querschnittsansichten zum Verfahren zum Herstellen einer Vorrichtung mit mindestens einem lichtemittierenden Bauelement gemäß verschiedenen Ausführungsformen; und
- Figur 5: schematische Aufsichten zum Verfahren zum Herstellen einer Vorrichtung mit mindestens einem lichtemittierenden Bauelement gemäß verschiedenen Ausführungsformen.

In der folgenden ausführlichen Beschreibung wird auf die beigefügten Zeichnungen Bezug genommen, die Teil dieser bilden und in denen zur Veranschaulichung spezifische Ausführungsformen gezeigt sind, in denen die Erfindung ausgeübt werden kann. In dieser Hinsicht wird Richtungsterminologie wie etwa "oben", "unten", "vorne", "hinten", "vorderes", "hinteres", usw. mit Bezug auf die Orientierung der beschriebenen Figur(en) verwendet. Da Komponenten von Ausführungsformen in einer Anzahl verschiedener Orientierungen positioniert werden können, dient die Richtungsterminologie zur Veranschaulichung und ist auf keinerlei Weise einschränkend. Es versteht sich, dass andere Ausführungsformen benutzt und strukturelle oder logische Änderungen vorgenommen werden können, ohne von dem Schutzumfang der vorliegenden Erfindung abzuweichen. Es versteht sich, dass die Merkmale der hierin beschriebenen verschiedenen beispielhaften Ausführungsformen miteinander kombiniert werden können, sofern nicht spezifisch anders angegeben. Die folgende ausführliche Beschreibung ist deshalb nicht in einschränkendem Sinne aufzufassen, und der Schutzumfang der vorliegenden Erfindung wird durch die angefügten Ansprüche definiert.

Im Rahmen dieser Beschreibung werden die Begriffe "verbunden", "angeschlossen" sowie "gekoppelt" verwendet zum Beschreiben sowohl einer direkten als auch einer indirekten Verbindung, eines direkten oder indirekten Anschlusses sowie einer direkten oder indirekten Kopplung. In den Figuren werden identische oder ähnliche Elemente mit identischen Bezugszeichen versehen, soweit dies zweckmäßig ist.

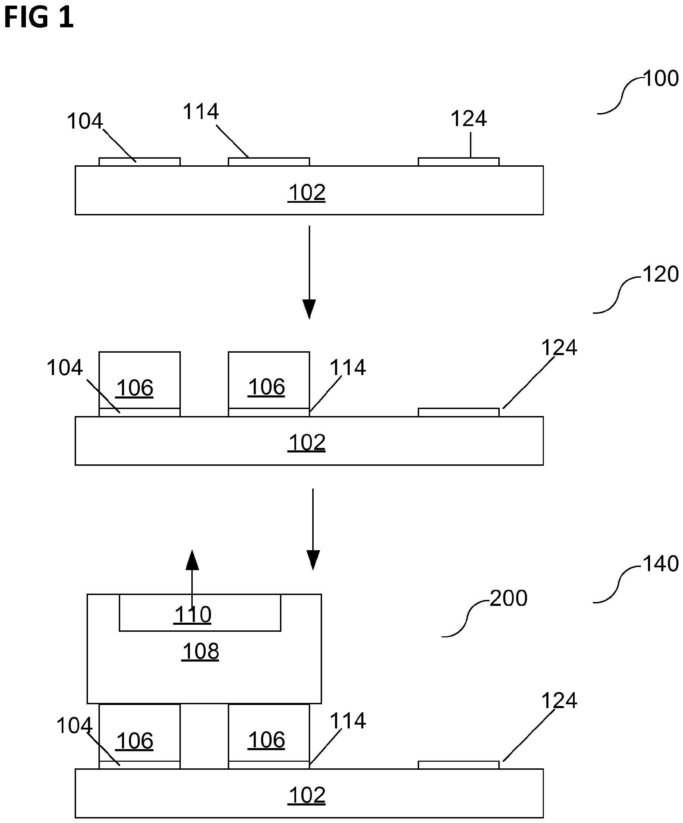

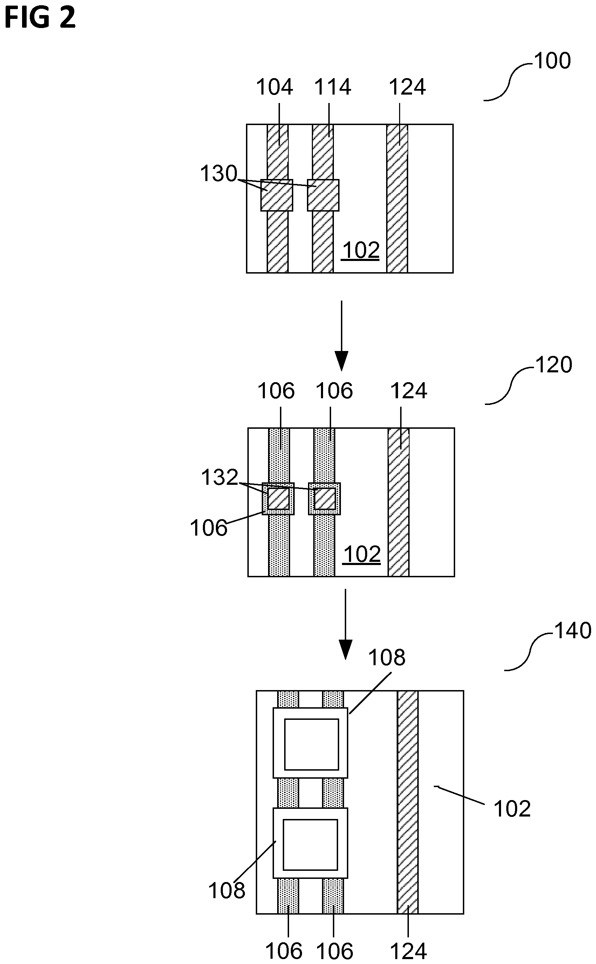

**FIG.1** zeigt schematische Querschnittsansichten und **FIG.2** zeigt schematische Aufsichten zum Verfahren zum Herstellen einer Vorrichtung 200 mit mindestens einem lichtemittierenden Bauelement 108 gemäß verschiedenen Ausführungsformen.

In verschiedenen Ausführungsbeispielen weist ein Verfahren zum Herstellen einer lichtemittierenden Vorrichtung ein Ausbilden 100 eines Trägers 102 mit mindestens einer Leiterbahn 104, 114, 124 auf einer Oberfläche des Trägers 102 auf. Das Ausbilden 100 ist beispielsweise ein Bereitstellen. Der Träger 102 kann eine Folie sein, die als eine Rolle aufgewickelt ist. Alternativ ist der Träger 102 ein einzelnes Folienstück, beispielsweise ausgerollt handhabbar.

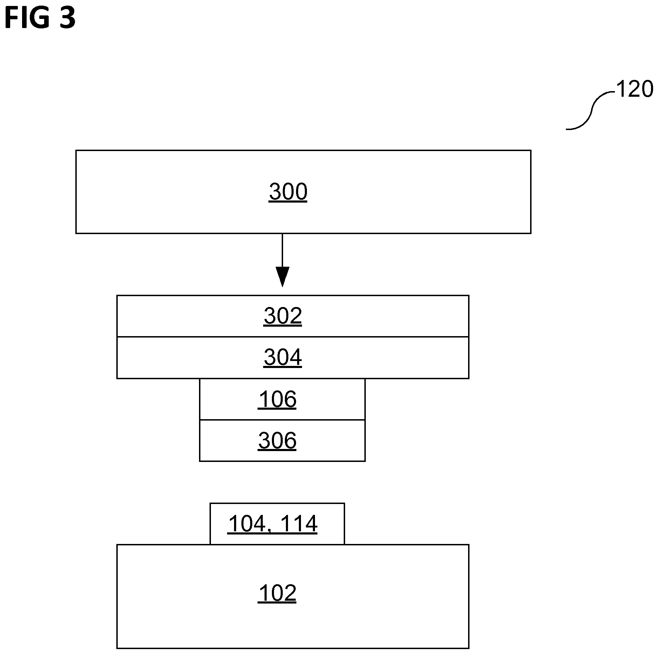

Das Verfahren weist ferner ein Ausbilden 120 einer reflektierenden Beschichtung 106 direkt auf der mindestens einen Leiterbahn 104, 114 mittels eines Folientransfer-Verfahrens auf (siehe auch FIG.3). Dabei wird die Leiterbahn 104 im Wesentlichen von der reflektierenden Beschichtung 106 bedeckt.

Dies ermöglicht ein einfacheres Ausbilden einer reflektierenden Beschichtung auf oder über einem Träger 102 und/oder einer Leiterbahn 104. Weitere Vorteile sind oben bzw. nachfolgend ausführlicher beschrieben.

In verschiedenen Ausführungsbeispielen wird die reflektierende Beschichtung 106 mittels eines kalten Folientransfer-Verfahrens auf oder über dem Träger aufgebracht. Alternativ wird die reflektierende Beschichtung mittels eines heißen Folientransfer-Verfahrens auf oder über dem Träger aufgebracht. Bei einem heißen Folientransfer-Verfahren wird im Gegensatz zu einem kalten Folientransfer-Verfahren der Träger 102 und/oder die reflektierende Beschichtung erwärmt und so ein Klebstoff zwischen dem Träger 102 und der reflektierenden Beschichtung ausgehärtet.

Es ist jedoch anwendungsspezifisch nicht erforderlich, dass jede Leiterbahn 124 mit einem lichtemittierenden Bauelement 108 verbunden ist und/oder mit einer reflektierenden Beschichtung 106 bedeckt wird (veranschaulicht in FIG.2). Beispielsweise kann eine Leiterbahn 124, die nicht direkt mit einem lichtemittierenden Bauelement 108 und/oder reflektierender Beschichtung verbunden ist (in FIG. 2 die rechts veranschaulichte Leiterbahn 124), dazu verwendet werden, unterschiedliche elektrische Verschaltungen der lichtemittierenden Bauelemente 108 zu realisieren.

Weiterhin weist das Verfahren ein Anordnen 160 eines lichtemittierenden Bauelementes 108 auf oder über der reflektierenden Beschichtung 106 auf. Das lichtemittierende Bauelement 108 wird elektrisch leitend mit der mindestens einen Leiterbahn 104, 114 verbunden (in FIG.2 sind zwei lichtemittierende Bauelemente 108 veranschaulicht). Die mehreren lichtemittierenden Bauelemente 108 können gleich oder unterschiedlich zueinander eingerichtet sein. Beispielsweise können die lichtemittierenden Bauelemente 108 Licht unterschiedlicher Farbe emittieren bzw. dementsprechend eingerichtet sein.

In verschiedenen Ausführungsbeispielen weist das lichtemittierenden Bauelement 108 einen lichtemittierenden Bereich 110 auf, der derart bezüglich des Trägers 102 eingerichtet ist, dass Licht im Wesentlichen von dem Träger 102 weg emittiert wird (in FIG.1 mittels des Pfeils 110 veranschaulicht). In verschiedenen Ausführungsbeispielen kann mindestens ein Teil des von dem lichtemittierenden Bauelement 108 emittierbaren Lichts in Richtung des Trägers 102 emittiert und an der reflektierenden Beschichtung 106 reflektiert werden. Dadurch kann die Effizienz und Lichtausbeute der lichtemittierenden Vorrichtung verbessert werden.

In FIG. 2 ist veranschaulicht, dass auf der Oberfläche des Trägers 102 ferner mindestens ein Kontaktpad 130 ausgebildet sein kann, das elektrisch leitend mit der mindestens einen Leiterbahn 104, 114 verbunden ist. Die reflektierende Beschichtung 106 ist in verschiedenen Ausführungsbeispielen derart auf oder über dem Kontaktpad 130 ausgebildet, dass mindestens ein Teil 132 des Kontaktpads 130 freiliegt. Die reflektierende Beschichtung 106 kann dadurch als eine Lötstopp-Struktur für das Kontaktpad 130 wirken. Eine Lötstopp-Struktur bewirkt, dass ein verflüssigtes Lot nicht verlaufen kann. Die Lötstopp-Struktur wirkt somit als eine Dammstruktur bzw. Bank für ein verflüssigtes Lot.

Das lichtemittierende Bauelement 108 kann durch den freiliegenden Teil 132 des Kontaktpads 130 elektrisch leitend mit der mindestens einen Leiterbahn 104, 114 verbunden werden. Beispielsweise wird eine Lötverbindung zwischen dem lichtemittierenden Bauelement 108 und dem freiliegenden Teil 132 des Kontaktpads 130 ausgebildet, beispielsweise mittels eines Reflow-Löt-Prozesses.

In verschiedenen Ausführungsbeispielen weist der Träger 102 mindestens eine erste Leiterbahn 104 und eine von der ersten Leiterbahn 104 elektrisch isolierte zweite Leiterbahn 114 auf. Die reflektierende Beschichtung 106 wird mit einem ersten Abschnitt ausgebildet, der direkt auf der ersten Leiterbahn 104 ausgebildet wird, und wird mit einem zweiten Abschnitt ausgebildet, der direkt auf der zweiten Leiterbahn 114 ausgebildet wird.

In verschiedenen Ausführungsbeispielen ist der erste Abschnitt der reflektierenden Beschichtung 106 elektrisch isoliert von dem zweiten Abschnitt der reflektierenden Beschichtung 106. Mit anderen Worten: die reflektierende Beschichtung 106 kann eine laterale Strukturierung aufweisen, die räumlich separierte Bereiche aufweist.

Die reflektierende Beschichtung sollte aus einem Material gebildet werden, dass in der Lage ist durch das Herstellungsverfahren zum Herstellen der Vorrichtung mit mindestens einem lichtemittierenden Bauelement ohne Beschädigung oder Beeinträchtigung seiner Funktion oder seiner physikalischen Eigenschaften hindurch zu kommen, beispielsweise während eines Reflow-Löt-Prozesses.

In verschiedenen Ausführungsbeispielen wird die reflektierende Beschichtung 106 elektrisch leitend ausgebildet. Beispielsweise weist die reflektierende Beschichtung 106 ein Metall auf oder wird daraus gebildet. Das Metall der reflektierenden Beschichtung 106 weist beispielsweise eine höhere Reflektivität auf als das Material der mindestens einen Leiterbahn 104, 114, 124.

In verschiedenen Ausführungsbeispielen wird die reflektierende Beschichtung 106 elektrisch nicht-leitend ausgebildet. Beispielsweise weist die nicht-leitende, reflektierende Beschichtung 106 hochreflektierende Partikel, beispielsweise aus Titanoxid, eingebettete in einer Polymermatrix auf.

In verschiedenen Ausführungsbeispielen wird das mindestens eine lichtemittierende Bauelement 108 mittels eines schlüssigen Verbindungsverfahrens auf oder über der Leiterstruktur angeordnet, beispielsweise mittels eines Reflow-Prozesses eines Lot bzw. von Lot-Kugeln, die zwischen lichtemittierendem Bauelement 108 und Kontaktpad 130, bzw. dessen freiliegenden Bereichs 132 oder einer freiliegenden Leiterbahn angeordnet sind.

Die elektrische Anbindung des lichtemittierenden Bauelementes mit einer oder mehreren Leiterbahnen 104 kann alternativ oder zusätzlich mittels Verklebens mittels eines elektrisch leitfähigen Klebstoffes (anisotropic conductive film bonding - ACF-Bonden), eines Reibschweißprozesses (Ultraschall-Bonden) oder ähnlichem, erfolgen.

Ein Anschluss bzw. mehrere Anschlüsse des lichtemittierenden Bauelements 108 kann/können beispielsweise mit einem oder mehreren Kontaktpad(s) der mindestens einen Leiterbahn 104 elektrisch leitend verbunden werden. Das lichtemittierende Bauelement 108 kann beispielsweise durch die Leiterbahn 104 von einer externen Stromquelle bestromt werden. Die elektrische Verbindung des elektrischen Anschlusses mit einem Kontaktpad und/oder der Leiterbahn 104 wird beispielsweise mittels einer Lötverbindung an einer Lötstelle mechanisch gesichert.

In verschiedenen Ausführungsbeispielen ist der Träger 102 eine flexible Folie oder weist eine solche auf. Beispielsweise ist der Träger 102 eine Kunststofffolie oder weist eine solche auf. In verschiedenen Ausführungsbeispielen weist der Träger 102 eine metallische Beschichtung auf.

In verschiedenen Ausführungsbeispielen ist der Träger 102 eine FR1-, FR2-, FR3-, FR4-, FR5-, CEM1-, CEM2-, CEM3-, CEM4- oder CEM5-Leiterplatte, beispielsweise eine durchkontaktierte FR-4-Leiterplatte.

Der Träger 102 kann transluzent oder transparent ausgebildet sein. Der Träger 102 dient als Trägerelement für elektronische Elemente oder Schichten, beispielsweise das mindestens lichtemittierende Bauelement. Der Träger 102 kann beispielsweise Glas, Quarz, und/oder ein Halbleitermaterial oder irgendein anderes geeignetes Material aufweisen oder daraus gebildet sein. Ferner kann der Träger 102 eine Kunststofffolie oder ein Laminat mit einer oder mit mehreren Kunststofffolien aufweisen oder daraus gebildet sein. Der Träger 102 weist beispielsweise eine Kapton-Folie (Polyimide, PI), eine Metallfolie oder eine PET-Folie auf. Beispielsweise kann der Träger 102 eine Stahlfolie, eine Kunststofffolie oder ein Laminat mit einer oder mit mehreren Kunststofffolien aufweisen oder daraus gebildet sein. Der Kunststoff kann ein oder mehrere Polyolefine (beispielsweise Polyethylen (PE) mit hoher oder niedriger Dichte oder Polypropylen (PP)) aufweisen oder daraus gebildet sein. Ferner kann der Kunststoff Polyvinylchlorid (PVC), Polystyrol (PS), Polyester und/oder Polycarbonat (PC), Polyethylenterephthalat (PET), Polyethersulfon (PES), PEEK, PTFE und/oder Polyethylennaphthalat (PEN) aufweisen oder daraus gebildet sein. Der Träger 102 kann ein Metall aufweisen oder daraus gebildet sein, beispielsweise Kupfer, Silber, Gold, Platin, Eisen, beispielsweise eine Metallverbindung, beispielsweise Stahl. Der Träger 102 kann als Metallfolie oder metallbeschichtete Folie ausgebildet sein. Der Träger 102 kann eines oder mehrere der oben genannten Materialien aufweisen. Der Träger 102 kann ein Teil einer Spiegelstruktur sein oder diese bilden. Der Träger 102 kann einen mechanisch rigiden Bereich und/oder einen mechanisch flexiblen Bereich aufweisen oder derart ausgebildet sein.

In verschiedenen Ausführungsbeispielen kann der Träger 102 eine metallbeschichtet Folie sein. Die metallbeschichtete Folie weist beispielsweise eine Metallschicht auf einer oben beschriebenen Kunststofffolie auf. Die Aufwachsschicht 104 kann direkt auf der Kunststofffolie ausgebildet sein. Die Metallschicht kann als Kühlkörper bzw. Wärmeleitstruktur und/oder hermetisch dichte Schicht gegenüber Wasser und Sauerstoff bezüglich der Kunststofffolie und/oder dem mindestens einen lichtemittierenden Bauelement dienen. Der Kühlkörper, die Wärmeleitstruktur bzw. die Metallschicht kann zur Entwärmung der Vorrichtung eingerichtet sein, beispielsweise indem der Kühlkörper eine größere Oberfläche, Emissivität, einen größeren Konvektionskoeffizient und/oder eine größere Wärmeleitfähigkeit aufweist, als wenigstens ein weiterer Bereich der Vorrichtung, der mit dem Kühlkörper in einem thermischen Kontakt steht, beispielsweise ein lichtemittierendes Bauelement 108.

Die Metallschicht ist beispielsweise derart eingerichtet, dass sie als Produkt ihrer Dicke d und ihrer thermischen Leitfähigkeit k einen Wert von größer als ungefähr 1000 pW/K aufweist, beispielsweise größer als ungefähr 5000 pW/K, beispielsweise größer als ungefähr 20000 pW/K. Die Dicke der Metallschicht kann beispielsweise kleiner sein als ungefähr 10 mm, beispielsweise kleiner sein als ungefähr 2 mm, beispielsweise kleiner sein als ungefähr 100 µm.

Der Träger 102 kann beispielsweise eine Folie beschichtet mit Aluminium oder Kupfer sein oder aufweisen. Alternativ kann der Träger 102 beispielsweise eine Graphen oder Graphitbeschichtete Folie sein.

Im Rahmen dieser Beschreibung kann ein lichtemittierendes Bauelement 108 ein Halbleiterbauelement sein, welches elektromagnetische Strahlung bereitstellt, beispielsweise in Form einer bedrahteten Leuchtdiode, einer aufliegenden Leuchtdiode (surface mounted device - SMD) oder einer chip-on-board Leuchtdiode (Die).

Im Rahmen dieser Beschreibung kann ein Halbleiterchip, der elektromagnetische Strahlung bereitstellen kann, als LED-Chip verstanden werden.

Ein lichtemittierendes Bauelement 108 kann beispielsweise einen Halbleiterchip der elektromagnetische Strahlung bereitstellt aufweisen (bedrahtete LED, SMD) oder als ein Halbleiterchip der elektromagnetische Strahlung bereitstellt eingerichtet sein (chip-on-board).

Auf oder über dem Halbleiterchip kann eine Verpackung (Package) aufgebracht und/oder ausgebildet sein. Die Verpackung kann beispielsweise, als Verkapselung, optische Linse und/oder als Konverterelement ausgebildet sein.

Eine bedrahtete Leuchtdiode kann einen Halbleiterchip aufweisen, der elektromagnetische Strahlung bereitstellen kann, beispielsweise einen LED-Chip. Der Halbleiterchip kann beispielsweise mit einer Kunststoffkappe verkapselt sein. Die Kunststoffkappe kann den LED Chip während der Fertigung und im Betrieb vor äußeren, schädlichen Einflüssen, beispielsweise Sauerstoff und/oder Wasser, schützen.

Eine aufliegende Leuchtdiode (SMD) kann einen LED-Chip in einem Gehäuse aufweisen. Das Gehäuse kann mit einem Substrat schlüssig fixiert sein.

Eine chip-on-board-Leuchtdiode kann einen LED-Chip aufweisen, der auf einem Substrat fixiert ist, wobei der LED-Chip weder ein Gehäuse noch Kontaktpads aufweisen kann.

Die einzelnen Halbleiterchips können beispielsweise auf einem Substrat, beispielsweise einer Leiterplatine aufgebracht bzw. ausgebildet werden.

Die Halbleiterchips können mittels Kontaktpads mit der Leiterplatine verdrahtet sein (wire bonding). Die Verdrahtungen kann beispielsweise mittels Gold-Drähten erfolgen.

In verschiedenen Ausführungsbeispielen ist das lichtemittierende Bauelement 108 als eine Laserdiode eingerichtet.

**FIG.3** zeigt eine schematische Querschnittsansicht zum Verfahren zum Herstellen einer Vorrichtung mit mindestens einem lichtemittierenden Bauelement gemäß verschiedenen Ausführungsformen.

Insbesondere veranschaulicht FIG.3 das Ausbilden 120 einer reflektierenden Beschichtung 106 direkt auf der mindestens einen Leiterbahn 104, 114 mittels eines Folientransfer-Verfahrens gemäß verschiedenen Ausführungsbeispielen.

Die reflektierende Beschichtung 106 ist mittels einer lösbaren Beschichtung 304 an einem temporären Substrat 302 angebracht. Auf der gegenüberliegenden Seite ist eine Klebstoffschicht 306 angebracht, dass heißt zwischen der reflektierenden Beschichtung 106 und der mindestens einen Leiterbahn 104. Mittels eines Stempels 300 wird die Klebstoffschicht 306 mit dem Träger 102 und/oder der mindestens einen Leiterbahn 104 in Kontakt gebracht (in FIG.3 mittels des Pfeils veranschaulicht).

Anschließend wird mittels der Klebstoffschicht 306 eine Klebstoffverbindung zwischen der reflektierenden Beschichtung 106 und dem Träger 102 und/oder der mindestens einen Leiterbahn 104 ausgebildet, beispielsweise mittels Druck und Wärme beim heißen Folientransfer-Verfahren.

Weiterhin wird das temporäre Substrat 302 mittels der lösbaren Beschichtung 304 von der reflektierenden Beschichtung 106 abgelöst, beispielsweise abgezogen.

Anschaulich ist die Klebstoffverbindung zwischen der reflektierenden Beschichtung 106 und dem Träger 102 und/oder der mindestens einen Leiterbahn 104 stärker als die Klebstoffverbindung zwischen der reflektierenden Beschichtung 106 und der lösbaren Beschichtung 304, beispielsweise in der plastischen Phase der Klebstoffschicht 306 nach einer Abkühlung im heißen Folientransfer-Verfahren.

Mittels einer schnellen Abkühlung der Folie nach Erwärmen der Klebstoffschicht 306 im heißen Folientransfer-Verfahren verbleibt die reflektierende Beschichtung 106 auf oder über dem Träger 102, während der Rest der reflektierenden Beschichtung neben der lateralen Strukturierung, das heißt der Teil der reflektierenden Beschichtung, der nicht auf oder über dem Träger 102 aufgebracht werden soll, auf dem temporären Substrat 302 verbleibt und mit diesem vom Träger 102 entfernt wird.

Die Klebstoffschicht 306, die reflektierende Beschichtung 106, die lösbare Beschichtung 304 und das temporäre Substrat 302 bilden eine Transferfolie bzw. als eine solche bezeichnet werden.

Die Klebstoffschicht 306, die reflektierende Beschichtung 106 und/oder der Stempel 300 können eine laterale Strukturierung aufweisen, um die strukturierte reflektierende Beschichtung 106 auf oder über dem Träger 102 auszubilden. Der Stempel 300 kann für Rolle-zu-Rolle-Anwendungen eine zylinderförmige Form mit eingeprägter lateraler Strukturierung aufweisen und somit eine Prägeform ausbilden. Für Folienstück-Anwendungen kann die Prägeform flach sein.

Abhängig von den Eigenschaften des Klebstoffs der Klebstoffschicht 306 kann alternativ zu Druck und Wärme das Ausbilden der Klebstoffverbindung zwischen der reflektierenden Beschichtung und dem Träger 102 und/oder der mindestens einen Leiterbahn 104 mittels einer ultravioletten Strahlung erfolgen.

Beim kalten Folientransfer-Verfahren wird, beispielsweise ein Klebstoff entsprechend einer vorgegebenen, lateralen Strukturierung auf oder über den Träger 102 aufgedruckt. Anschließend wird eine Transferfolie mit oder ohne Klebstoffschicht 306 auf den Träger 102 laminiert. Die reflektierende Beschichtung ist beispielsweise vollflächig bzw. unstrukturiert auf dem temporären Substrat der Transferfolie angeordnet. Dadurch haften die zu transferierenden Materialien entsprechend dem gedruckten Klebstoff an dem Träger 102, wohingegen andere Teile an der Transferfolie verbleiben. Ferner kann das Verfahren ein kurzes thermisches Aushärten oder UV-Aushärten, beispielsweise im Bereich einiger Sekunden, aufweisen, um abschließend eine Klebstoffverbindung zwischen der reflektierenden Beschichtung 106 und dem Träger 102 bzw. der mindestens einen Leiterbahn 104 auszubilden.

Die Oberflächengüte der ausgebildeten, reflektierenden Beschichtung 106 auf oder über dem (flexiblen) Träger 102 wird durch die Oberflächengüte des temporären Substrates 302, die der reflektierenden Beschichtung gegenüberliegt, definiert. Diese Oberfläche des temporären Substrates 302 kann anwendungsspezifischen poliert oder mattiert werden. Dies ermöglicht ein hochwertiges Erscheinungsbild bei der ausgebildeten lichtemittierenden Vorrichtung.

In verschiedenen Ausgestaltungen kann der Klebstoff der Klebstoffschicht 306 einen der folgenden Stoffe aufweisen oder daraus gebildet sein: ein Kasein, ein Glutin, eine Stärke, eine Cellulose, ein Harz, ein Tannin, ein Lignin, einen organischen Stoff mit Sauerstoff. Stickstoff, Chlor und/oder Schwefel; ein Metalloxid, ein Silikat ein Phosphat, ein Borat.

In verschiedenen Ausgestaltungen kann der Klebstoff der Klebstoffschicht 306 als ein Schmelzklebstoff, beispielsweise ein lösemittelhaltiger Nassklebstoff, ein Kontaktklebstoff, ein Dispersionsklebstoff, ein Wasserbasierter Klebstoff, ein Plastisol; ein Polymerisationsklebstoff, beispielsweise ein Cyanacrylat-Klebstoff, ein Methylmethacrylat-Klebstoff, ein anaerob härtender Klebstoff, ein ungesättigter Polyester, ein Strahlenhärtender Klebstoff; ein Polykondensationsklebstoff, beispielsweise ein Phenol-Formaldehydharz-Klebstoff, ein Silikon, ein Silan-vernetzender Polymerklebstoff, ein Polyimidklebstoff, ein Polysulfidklebstoff; und/oder ein Polyadditionsklebstoffe, beispielsweise ein Epoxidharz-Klebstoff, ein Polyurethan-Klebstoff, ein Silikon, ein Haftklebstoff; aufweisen oder daraus gebildet sein.

Ein Schmelzklebstoff kann in verschiedenen Ausführungsbeispielen ein Werkstoff zum stoffschlüssigen Verbinden zweier Körper, beispielsweise des lichtemittierenden Bauelements 108 mit der Leiterbahn 104, sein. Der Schmelzklebstoff kann beispielsweise ein Werkstoff sein, der bei Zimmertemperatur hart ist und der zum Verbinden der Körper zunächst verflüssigt und dann wieder gehärtet wird. Dabei kann der Schmelzklebstoff bereits vor dem Verflüssigen oder erst in flüssigem Zustand mit den beiden Körpern in Kontakt gebracht werden. Der Schmelzklebstoff kann beispielsweise in einem Konvektionsofen oder einem Reflow-Ofen verflüssigt werden. Der Schmelzklebstoff kann beispielsweise einen Kunststoff, beispielsweise ein Kunstharz, und/oder ein Metall, beispielsweise ein Lot, aufweisen. Das Lot kann beispielsweise eine Legierung aufweisen. Das Lot kann beispielsweise Blei, Zinn, Zink, Kupfer, Silber, Aluminium, Silizium und/oder Glas und/oder organische oder anorganische Zusatzstoffen aufweisen.

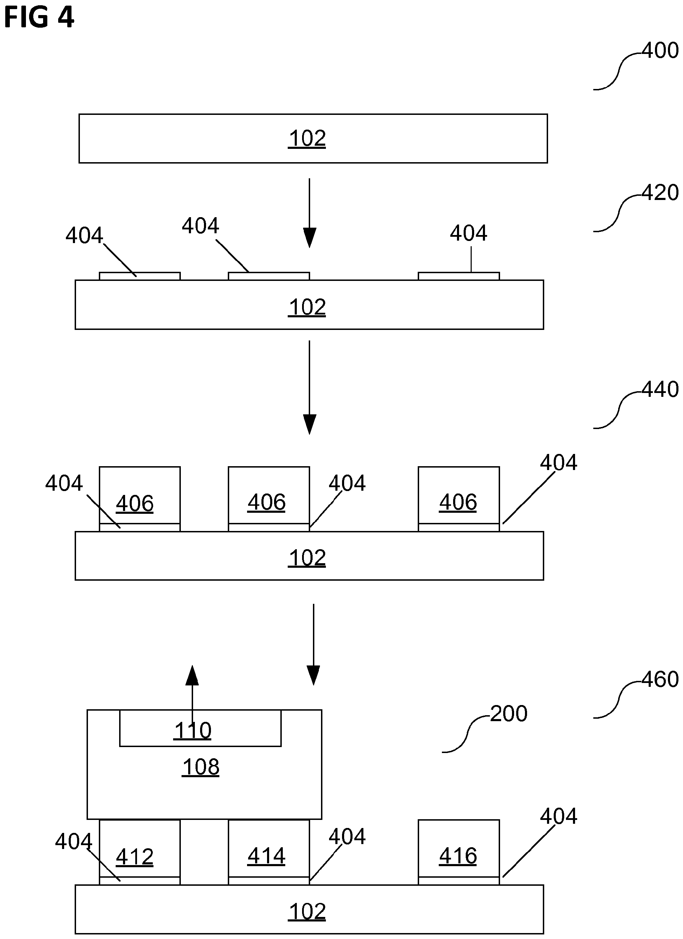

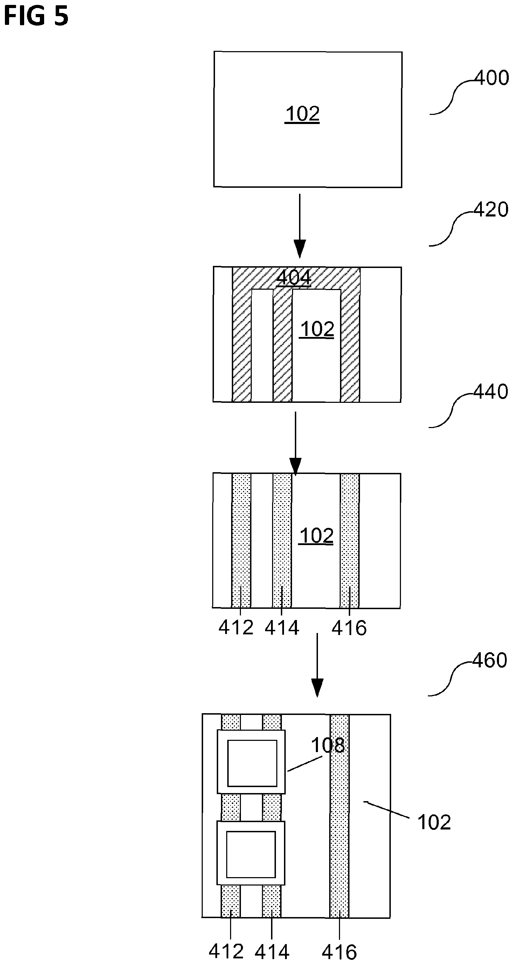

**FIG.4** zeigt schematische Querschnittsansichten und **FIG.5** zeigt schematische Aufsichten zum Verfahren zum Herstellen einer Vorrichtung 200 mit mindestens einem lichtemittierenden Bauelement 108 gemäß verschiedenen Ausführungsformen, die nicht zur Erfindung gehören. Die Vorrichtung 200 bzw. deren Komponenten können gemäß einer oben beschriebenen Ausführungsform eingerichtet sein.

Das Verfahren weist ein Bereitstellen 400 eines Trägers 102, ein Ausbilden 420 einer Aufwachsschicht 404 auf dem Träger 102, ein galvanisches Abscheiden 440 eines elektrisch leitenden Materials direkt auf der Aufwachsschicht 404 und ein Anordnen 460 des mindestens einen lichtemittierenden Bauelements 108 auf oder über der Leiterstruktur 406 auf. Mit anderen Worten: das Verfahren zum Herstellen der Vorrichtung mit mindestens einem lichtemittierenden Bauelement weist mindestens ein additives bzw. zweistufiges Verfahren auf, um die Leiterstruktur auszubilden. Dabei wird zunächst eine dünne Aufwachsschicht (auch bezeichnet als Keimschicht, (engl.) layout layer oder seed layer) ausgebildet, wobei die Aufwachsschicht eine laterale Strukturierung (auch bezeichnet als (engl.) layout) aufweist.

Dies ermöglicht das elektrisch leitendes Material der Leiterstruktur nur dort ausgebildet wird, wo es tatsächlich notwendig ist, und mit der erforderten Dicke, um die Schaltung in der gedruckten Leiterplatte, beispielsweise dem flexiblen Träger mit Leiterstruktur mit lateral er Strukturierung, zu realisieren. Dabei können speziell für lichtemittierende Bauelemente, erforderliche Anforderungen hinsichtlich der elektrischen Leitfähigkeit, der thermischen Leitfähigkeit, der Lötbarkeit und der Flammenbeständigkeit bei dem Design der Leiterstruktur berücksichtigt werden. Die Leiterstruktur kann beispielsweise einen Flächenanteil in einem Bereich von ungefähr 5 % bis ungefähr 95 % einer bedruckbaren Seite des Trägers einnehmen. Dadurch wird ein einfacherer und schlanker Herstellungsprozess für Vorrichtungen mit gedruckter Leiterplatten ermöglicht, was sich in geringeren Kosten für gedruckte Leiterplatte zeigt. Weiterhin wird ein umweltfreundlicher Herstellungsprozess ermöglicht, ohne dass ein selektiver Belichtungsprozess und ein Ätz-Prozess erforderlich wären.

Die Aufwachsschicht kann beispielsweise mittels einer physikalischen Gasphasenabscheidung durch eine wiederverwendbare Maske, welche die laterale Strukturierung aufweist, oder Abziehen nicht benötigten Materials, ausgebildet werden. Alternativ (nicht abschließend) kann die Aufwachsschicht mit lateraler Strukturierung mittels eines Folientransfers, bei der die laterale Strukturierung bereits vor dem Aufbringen der Aufwachsschicht auf dem Träger realisiert ist, realisiert werden.

Die Aufwachsschicht weist beispielsweise eine Dicke in einem Bereich von ungefähr 100 nm bis ungefähr 1 µm auf und ist elektrisch leitend. Beispielsweise ist die Aufwachsschicht aus einem elektrisch leitenden Material gebildet oder weist solches auf. Die ausgebildete Aufwachsschicht wird im Anschluss als eine Elektrode für einen galvanischen Prozess verwendet, um ein elektrisch leitendes Material direkt auf der Aufwachsschicht abzuscheiden, wodurch die Leiterstruktur mit lateraler Strukturierung ausgebildet wird. Die Leiterstruktur weist jedoch eine größere Dicke auf als die der Aufwachsschicht. Mit anderen Worten: mittels des galvanischen Abscheidens kann die Dicke der Leiterstruktur, deren laterale Struktur durch die Aufwachsschicht definiert wird, vergrößert werden. Dadurch können Anforderungen hinsichtlich der elektrischen und thermischen Leitfähigkeit, der Lötbarkeit, der Adhäsion der Leiterbahn an dem Träger, und die Zuverlässigkeit, die typisch für Beleuchtungs-Anwendungen sind, erfüllt werden.

Die Beleuchtungs-Anwendungen erfordern ein vorgegebenes bzw. dezidiertes Layout-Konzept für die Leiterstruktur, um eine maximale Flächenbedeckung der Fläche mit elektrisch leitendem Material der Leiterstruktur zu ermöglichen. Dies ermöglicht die minimale Dicke der Leiterstruktur zu reduzieren, wodurch das elektrisch leitende Material der Leiterstruktur einfacher und schneller abgeschieden werden kann.

Dies ermöglicht, dass beispielsweise Metall der Leiterstruktur nur dort ausgebildet wird, wo es tatsächlich notwendig ist, und mit der erforderlichen Dicke, um die Schaltung in der flexiblen gedruckten Leiterplatte zu realisieren. Dabei können speziell für lichtemittierende Bauelemente, erforderliche Anforderungen hinsichtlich der elektrischen Leitfähigkeit, der thermischen Leitfähigkeit, der Lötbarkeit und der Flammenbeständigkeit bei dem Design der Leiterstruktur berücksichtigt werden. Die Leiterstruktur kann beispielsweise einen Flächenanteil in einem Bereich von ungefähr 5 % bis ungefähr 95 % einer bedruckbaren Seite des Trägers einnehmen.

Dadurch wird ein einfacherer und schlanker Herstellungsprozess für flexible gedruckte Leiterplatten ermöglicht, was sich in geringeren Kosten für gedruckte Leiterplatte zeigt. Beispielsweise wird das herkömmliche Stoppen oder Ruhen der Folie zur Beleuchtung optional bzw. ist nicht mehr erforderlich.

Weiterhin wird ein umweltfreundlicher Herstellungsprozess ermöglicht, ohne dass ein selektiver Belichtungsprozess und ein Ätz-Prozess erforderlich wären.

Mittels des additiven Prozesses wird zudem weniger elektrisch leitendes Material beispielsweise Kupfer, während der Herstellung verschwendet. Für flächige Beleuchtungs-Module (engl. areal lighting module) können mit dem selektiven Abscheiden von elektrisch leitendem Material große Flächen mit elektrisch leitendem Material bedeckt werden, wobei elektrisch leitendes Material nur dort abgeschieden wird, wo es auch benötigt wird.

Für den Fall, dass die Aufwachsschicht mittels eines Klebstoffes auf dem Träger fixiert wird, ist deren Dicke optional gering verglichen mit einer Klebstoffschicht, die beispielsweise zum Auflaminieren einer Kupferfolie auf eine Kunststofffolie und nachträglichem Ätzen verwendet wird. Dadurch kann die Brennbarkeit des Trägers mit Leiterstruktur und der Materialbedarf reduziert werden.

Die elektrische und thermische Leitfähigkeit der Leiterbahn(en) der Leiterstruktur ist vergleichbar mit denen, der Volumeneigenschaften (engl. bulk conductivity) des elektrisch leitenden Materials und ähnlich denen der mittels Ätzens hergestellten Leiterbahn(en), aber höher als jene, die mit anderen möglichen Technologien, unter anderem mit Silber-Tinte gedruckte Layouts, hergestellt werden.

Weiterhin ist die Gesamtqualität-Ausbeute der flexiblen Leiterbahn höher, wodurch die Ausschussmenge reduziert werden kann. Dies ist insbesondere für Rolle-zu-Rolle Herstellungsverfahren mit elektrisch endlosen Leiterbahnen von Bedeutung. Bereits ein einzelner Fehler könnte sonst bereits zur Unterbrechung der Kontinuität des endlosen Produktes führen, wodurch eine hohe Abfallrate bzw. Ausschussrate bedingt wäre.

Weiterhin werden schnelle Prozesse ermöglicht. Weiterhin werden Rolle-zu-Rolle-Prozesse ohne Lücken oder Unterbrechungen oder zusätzlichen Toleranzen zwischen den einzelnen Prozessschritten ermöglicht.

Weiterhin kann eine große Folienbreite mit Standardmaschinen, die beispielsweise in der Verpackungsindustrie verwendet werden, ermöglicht werden. Dadurch kann die normal verarbeitbare Breite von herkömmlich verwendeten FPC-Herstellungsverfahren, die auf Ätz-Prozessen basieren, vergrößert werden.

In verschiedenen Ausführungsformen, die nicht zur Erfindung gehören, ist eine Vorrichtung bereitgestellt, aufweisend: eine Aufwachsschicht auf einem Träger, eine mindestens teilweise galvanisch abgeschiedene Leiterstruktur direkt auf der Aufwachsschicht; und mindestens ein lichtemittierendes Bauelement auf oder über der Leiterstruktur und mit dieser elektrisch leitend verbunden.

In verschiedenen Ausführungsformen, die nicht zur Erfindung gehören, weist die Aufwachsschicht 404 die laterale Strukturierung auf bzw. wird mit einer solchen ausgebildet. Die laterale Strukturierung ist in der schematischen Querschnittsansicht in FIG.4 mittels drei nebeneinander angeordneten Strukturen veranschaulicht. Die laterale Strukturierung kann zusammenhängend miteinander verbunden sein (in FIG.5 in Schritt 420 als kammförmige Struktur veranschaulicht) oder unterschiedliche Bereiche aufweisen, die jeweils für sich zusammenhängend verbunden sind (in FIG.5 in Schritt 440 als drei separat, nebeneinander angeordnete Leitungen veranschaulicht).

Die laterale Strukturierung kann beispielsweise eine oder mehrere Leiterbahnen aufweisen. Die Leiterbahnen können als Linienzüge ausgebildet sein, beispielsweise als Polygonenzug. Mit anderen Worten: In verschiedenen Ausführungsbeispielen, die nicht zur Erfindung gehören, weist die laterale Strukturierung der Aufwachsschicht 404 mindestens eine durchgehend zusammenhängende Leiterbahn auf.

In verschiedenen Ausführungsbeispielen, die nicht zur Erfindung gehören, weist die laterale Strukturierung zusätzlich mindestens ein Kontaktpad auf, das mit der Leiterbahn verbunden ist und zum externen elektrischen Kontaktieren eingerichtet ist, beispielsweise lötbar.

Die ausgebildete Aufwachsschicht 404 ist elektrisch leitend, so dass das elektrisch leitende Material zum Ausbilden der Leiterstruktur galvanisch direkt auf der Aufwachsschicht 404 abgeschieden werden kann. Dadurch wird eine Leiterstruktur 406 auf der Aufwachsschicht 404 ausgebildet. Die Leiterstruktur 406 kann dabei im Wesentlichen oder vollständig die laterale Struktur der Aufwachsschicht 404 abbilden bzw. nachbilden. Der Querschnitt einer galvanischen ausgebildeten Leiterbahn der Leiterstruktur zeigt im Wesentlichen eine Struktur, ähnlich einer Volumen-Struktur (engl. bulk structure) des elektrisch leitenden Materials. Eine solche Volumen-Struktur unterscheidet sich beispielsweise von einer gedruckten Struktur des elektrisch leitenden Materials. Beispielsweise zeigt eine gedruckte Kupfer-Leiterbahn Unregelmäßigkeiten in den Kupferpartikeln einer kupferhaltigen Tinte bzw. Druckpaste und eine elektrische Leitfähigkeit wird durch die Kontaktpunkte zwischen den Partikeln erreicht. Die Leitfähigkeit der Leiterstruktur bzw. der Leiterbahn(en) der Leiterstruktur ähnlich der Volumeneigenschaften des elektrisch leitenden Materials ist relevant für die Eigenschaften der flexiblen Leiterplatte (FPC), da die elektrische Leitfähigkeit höher ist als beispielsweise bei einer gedruckten Leiterbahn mit dem gleichen Querschnitt.

In verschiedenen Ausführungsbeispielen, die nicht zur Erfindung gehören, wird die Aufwachsschicht 404 mittels eines Folientransfers auf dem Träger 102 ausgebildet. Der Folientransfer kann beispielsweise heiß oder kalt erfolgen. Zudem kann (optional) ein Adhäsionsverstärker verwendet werden.

Beim Folientransfer-Verfahren ist die Aufwachsschicht 404 mittels einer lösbaren Beschichtung an einem temporären Substrat, beispielsweise einer PET-Folie, angebracht. Die Aufwachsschicht 404 wird beispielsweise mittels einer physikalischen Gasphasenabscheidung auf der lösbaren Beschichtung aufgedampft. Auf der gegenüberliegenden Seite der Aufwachsschicht 404 ist eine Klebstoffschicht angebracht, das heißt zwischen der Aufwachsschicht 404 und dem Träger 102. Die Klebstoffschicht kann beispielswiese ausgebildet werden, indem eine Rolle aus Träger 102, lösbarer Beschichtung und Aufwachsschicht 404 "endlos" über eine Klebeschicht auf dem Träger 102. Mittels eines Stempels wird der Träger 102 mit der Aufwachsschicht durch die Klebstoffschicht in Kontakt gebracht.

Anschließend wird mittels der Klebstoffschicht eine Klebstoffverbindung zwischen der Aufwachsschicht 404 und dem Träger 102 ausgebildet, beispielsweise mittels Druck und Wärme beim heißen Folientransfer-Verfahren.

Weiterhin wird das temporäre Substrat mittels der lösbaren Beschichtung von der Aufwachsschicht 404 abgelöst, beispielsweise abgezogen.

Mit anderen Worten: nur die Aufwachsschicht bleibt auf der Klebstoffschicht hängen. Das temporäre Substrat kann anschließend entsorgt oder wiederverwendet werden.

Anschaulich ist die Klebstoffverbindung zwischen der Aufwachsschicht 404 und dem Träger 102 stärker als die Klebstoffverbindung zwischen der Aufwachsschicht 404 und der lösbaren Beschichtung, beispielsweise in der plastischen Phase der Klebstoffschicht nach einer Abkühlung im heißen Folientransfer-Verfahren.

Mittels einer schnellen Abkühlung der Folie nach Erwärmen der Klebstoffschicht im heißen Folientransfer-Verfahren verbleibt die Aufwachsschicht 404 auf oder über dem Träger 102, während der Rest der aufzubringenden Aufwachsschicht 404 auf dem temporären Substrat verbleibt und mit diesem vom Träger 102 entfernt wird.

Die Klebstoffschicht, die Aufwachsschicht, die lösbare Beschichtung und das temporäre Substrat bilden eine Transferfolie bzw. als eine solche bezeichnet werden.

Die Klebstoffschicht, die Aufwachsschicht 404 und/oder der Stempel können eine laterale Strukturierung aufweisen, um die strukturierte Aufwachsschicht 404 auf oder über dem Träger 102 auszubilden. Der Stempel kann für Rolle-zu-Rolle-Anwendungen eine zylinderförmige Form mit eingeprägter lateraler Strukturierung aufweisen und somit eine Prägeform ausbilden. Für Folienstück-Anwendungen kann die Prägeform flach sein.

Abhängig von den Eigenschaften des Klebstoffs der Klebstoffschicht kann alternativ zu Druck und Wärme das Ausbilden der Klebstoffverbindung zwischen der reflektierenden Beschichtung und dem Träger 102 mittels einer ultravioletten Strahlung erfolgen.

Beim kalten Folientransfer-Verfahren wird, beispielsweise ein Klebstoff entsprechend einer vorgegebenen, lateralen Strukturierung auf oder über den Träger 102 aufgedruckt. Anschließend wird eine Transferfolie mit oder ohne Klebstoffschicht auf den Träger 102 laminiert. Die Aufwachsschicht 404 ist beispielsweise vollflächig bzw. unstrukturiert auf dem temporären Substrat der Transferfolie angeordnet. Dadurch haften die zu transferierenden Materialien entsprechend dem gedruckten Klebstoff an dem Träger 102, wohingegen andere Teile an der Transferfolie verbleiben. Ferner kann das Verfahren ein kurzes thermisches Aushärten oder UV-Aushärten, beispielsweise im Bereich einiger Sekunden, aufweisen, um abschließend eine Klebstoffverbindung zwischen der Aufwachsschicht 404 und dem Träger 102 auszubilden.

Die Oberflächengüte der ausgebildeten, Aufwachsschicht 404 auf oder über dem (flexiblen) Träger 102 wird durch die Oberflächengüte des temporären Substrates, die der Aufwachsschicht 404 gegenüberliegt, definiert. Diese Oberfläche des temporären Substrates kann anwendungsspezifischen poliert oder mattiert werden. Dies ermöglicht ein hochwertiges Erscheinungsbild bei der ausgebildeten lichtemittierenden Vorrichtung.

Mit anderen Worten: das elektrisch leitende Material ist dazu mit der lateralen Strukturierung auf einer lösbaren Verbindungsschicht (engl. release coater) über einem temporären Träger angeordnet, wobei eine Klebstoffschicht bzw. der Adhäsionsverstärker auf der Oberfläche des elektrisch leitenden Materials mit der lateralen Strukturierung aufgebracht ist. Mittels eines Stempels (engl. stamping die) und der Klebstoffschicht bzw. dem Additionsverstärker wird das elektrisch leitende Material mit der lateralen Strukturierung auf der Oberfläche des Trägers 102 aufgebracht, wobei sich die Klebstoffschicht zwischen dem Träger 102 und der Aufwachsschicht befindet. Der temporäre Träger wird mittels der lösbaren Verbindungsschicht von dem elektrisch leitenden Material mit der lateralen Strukturierung abgezogen, wodurch die Aufwachsschicht 404 mit lateraler Strukturierung auf dem Träger 102 ausgebildet wird.

Beispielsweise ist der Klebstoff der Klebstoffschicht ein Schmelzkleber. Alternativ oder zusätzlich ist der Klebstoff der Klebstoffschicht ein mittels ultravioletten Lichts (UV)-aushärtender Klebstoff.

Mit anderen Worten: der Klebstoff der Klebstoffschicht kann ein UV-aushärtender Kleber sein, der aufgetragen wird und, da die Aufwachsschicht, beispielsweise in Form einer Kupferschicht, dünn ist, reicht anschließend ein UV-Blitz aus, um den Klebstoff der Klebstoffschicht auszuhärten. Die Strahlung des UV-Blitzes geht dabei durch die dünne Aufwachsschicht. Alternativ oder zusätzlich ist der Klebstoff der Klebstoffschicht ein Thermoplast, der vollflächig auf eine dünne, unstrukturierte Aufwachsschicht aufgebracht wird, der mittels einer zylindrischen, heißen Prägewalze passend aufgeschmolzen wird und nur an aufgeschmolzenen Bereichen auf dem Träger 102 haftet. Weitere Klebstoffe werden unten noch ausführlicher beschrieben.

In verschiedenen, die zur Erfindung nicht gehören, wird die Aufwachsschicht 404 mittels einer physikalischen Gasphasenabscheidung auf dem Träger 102 ausgebildet. Beispielsweise wird das Material der Aufwachsschicht mittels physikalischer Gasphasenabscheidung ganzflächig auf dem Träger mit einer Dicke von beispielsweise 100 nm bis ungefähr 1 µm, beispielsweise bis ungefähr 200 nm abgeschieden. Anschließend kann Material der Aufwachsschicht, das nicht erforderlich ist, entfernt, beispielsweise abgezogen werden, um die laterale Strukturierung in der Aufwachsschicht auszubilden. Beispielsweise wird geschmolzenes Kupfer aus einem Kupferbad als gleichförmige Schicht auf einer Seite eines Trägers in Folienform, der über eine Rolle geführt wird, mittels physikalischer Gasphasenabscheidung (PVD) im Vakuum abgeschieden werden. Um das Entfernen nicht benötigten Materials der Aufwachsschicht, um die laterale Strukturierung auszubilden, zu erleichtern, kann zuvor zwischen dem Material der Aufwachsschicht und dem Träger ein Adhäsions-Verhinderer in den Bereichen, in denen in der lateralen Strukturierung keine Aufwachsschicht vorgesehen ist, ausgebildet werden und anschließend elektrisch leitendes Material vollflächig über der Oberfläche des Trägers abgeschieden werden. Das Material der Aufwachsschicht weist in Bereichen mit Adhäsions-Verhinderer eine geringere Adhäsion und/oder Köhasion auf als in Beriech ohne Adhäsions-Verhinderer. Dadurch kann das Ausbilden der lateralen Strukturierung der Aufwachsschicht vereinfacht werden.

In verschiedenen Ausführungsbeispielen, die nicht zur Erfindung gehören, wird die Aufwachsschicht 404 mittels eines Druckverfahrens auf dem Träger 102 ausgebildet, beispielsweise einem Stempeldruck, einem Siebdruck, einem Rotationsgravurdruck (engl. rotogravur ink printing) und/oder einem Tintenstrahldruck. Eine gedruckte Aufwachsschicht 404 weist üblicherweise eine Dicke von einigen Mikrometern oder weniger auf.

In verschiedenen Ausführungsbeispielen, die nicht zur Erfindung gehören, weist die Aufwachsschicht 404 mehrere, elektrisch voneinander isolierte Bereiche auf. Dadurch kann beispielsweise eine Leiterstruktur mit unterschiedlichen Materialien oder Schichtdicken ausgebildet werden.

In verschiedenen Ausführungsbeispielen, die nicht zur Erfindung gehören, sind die Aufwachsschicht 404 und der Träger 102 elektrisch voneinander isoliert eingerichtet. Mit anderen Worten zwischen der Aufwachsschicht 404 und dem Träger 102 besteht keine elektrisch leitende Verbindung. Beispielsweise ist die Oberfläche des Trägers 102, auf oder über der die Aufwachsschicht 404 ausgebildet wird, von einem elektrisch nicht-leitenden Material gebildet. Alternativ sind die Aufwachsschicht 404 und der Träger 102 elektrisch leitend miteinander verbunden.

In verschiedenen Ausführungsbeispielen, die nicht zur Erfindung gehören, wird zum galvanischen Abscheiden des elektrisch leitenden Materials, das die Leiterstruktur bildet, ein elektrisches Potential an die Aufwachschicht 404 angelegt. Das elektrische Potential ist abhängig von dem Material der Aufwachsschicht und dem galvanisch abzuscheidenden Material.

In verschiedenen Ausführungsbeispielen, die nicht zur Erfindung gehören, ist das galvanisch abgeschiedene Material gleich dem Material der Aufwachsschicht 404. Alternativ ist das galvanisch abgeschiedene Material unterschiedlich zu dem Material der Aufwachsschicht 404. Beispielsweise ist das elektrisch leitende Material ein Metall, beispielsweise Kupfer. In verschiedenen Ausführungsbeispielen, die nicht zur Erfindung gehören, weist die Aufwachsschicht 404 eines der folgenden Materialien auf, ist daraus gebildet oder weist eine Legierung davon auf: Kupfer, Silber, Chrom, Magnesium. Alternativ oder zusätzlich ist das elektrisch leitende Material ein Halbmetall oder weist ein solches auf. Vor dem galvanischen Abscheiden kann das Verfahren ferner ein Entfernen mindestens eines Teils der Aufwachsschicht 404 aufweisen. Dadurch kann mindestens eine erste Leiterbahn und eine zweite Leiterbahn, die von der ersten Leiterbahn elektrisch isoliert ist, ausgebildet werden (in FIG.4 und FIG. 2 als separierte Leiterbahnen 412, 414, 416 veranschaulicht). Die erste und zweite Leiterbahnen können somit zueinander unterschiedliche Dicken oder aus zueinander unterschiedlichem Material ausgebildet werden.

Vor dem Anordnen des mindestens einen lichtemittierenden Bauelements 108 kann das Verfahren ferner ein Entfernen mindestens eines Teils der Leiterstruktur 406 aufweisen. Dadurch kann mindestens eine erste Leiterbahn und eine zweite Leiterbahn, die von der ersten Leiterbahn elektrisch isoliert ist, ausgebildet werden (in FIG.5 veranschaulicht).

Die Leiterstruktur 406 weist mindestens eine Leiterbahn auf, wobei die eine Leiterbahn aufweist: eine Querschnittsfläche in einem Bereich von ungefähr 0,02 mm² bis ungefähr 4 mm²; eine Breite der Querschnittsfläche in einem Bereich von ungefähr 0,5 mm bis ungefähr 4 mm und/oder eine Höhe der Querschnittsfläche in einem Bereich von ungefähr 0,15 µm bis ungefähr 400 µm, beispielsweise in einem Bereich von ungefähr 0,15 µm bis ungefähr 100 µm.

Mit anderen Worten: in verschiedenen Ausführungsbeispielen, die nicht zur Erfindung gehören, weist mindestens eine Leiterbahn, beispielsweise jede Leiterbahn, der Leiterstruktur 406, auf oder über der das lichtemittierende Bauelement 108 angeordnet wird, eine Querschnittsfläche in einem Bereich von ungefähr 0,02 mm² bis ungefähr 4 mm² auf. Beispielsweise weist eine Leiterbahn jeweils eine Höhe in einem Bereich von ungefähr 0,5 mm bis ungefähr 4 mm auf. Beispielsweise weist eine Leiterbahn jeweils eine Breite in einem Bereich von ungefähr 0,15 µm bis ungefähr 400 µm auf, beispielsweise in einem Bereich von ungefähr 0,15 µm bis ungefähr 100 µm.

In verschiedenen Ausführungsbeispielen, die nicht zur Erfindung gehören, wird eine Leiterbahn so breit wie möglich gebildet, wobei die Breite der Leiterbahn allein durch die elektrische Isolierung zu der lateral benachbarten Leiterbahn beschränkt sein kann. In verschiedenen Ausführungsbeispielen, die nicht zur Erfindung gehören, weist eine Leiterbahn zudem eine verfahrensbedingte minimale Länge auf.

In verschiedenen Ausführungsbeispielen, die nicht zur Erfindung gehören, ist das galvanisch aufgebrachte, elektrisch leitende Material der Leiterstruktur ein Metall, beispielsweise Kupfer, und wird zur Entwärmung bzw. zur Wärmeverteilung verwendet bzw. ist diesbezüglich optimiert, beispielsweise bezüglich der Querschnittsfläche und/oder Strukturierung.

Auf oder über der Leiterstruktur 406 wird mindestens ein lichtemittierendes Bauelement 108 angeordnet und mit mindestens einer Leiterbahn 412, 414 der Leiterstruktur 406 elektrisch leitend verbunden (in FIG.5 sind zwei lichtemittierende Bauelemente 108 veranschaulicht).

In verschiedenen Ausführungsbeispielen weist das lichtemittierenden Bauelement einen lichtemittierenden Bereich auf, der derart bezüglich dem Träger eingerichtet ist, dass Licht im Wesentlichen von dem Träger 102 weg (in FIG. 1 mittels des Pfeils 110 veranschaulicht) emittiert wird. In verschiedenen Ausführungsbeispielen kann der Träger 102 transparent eingerichtet sein und mindestens ein Teil des von dem lichtemittierenden Bauelement 108 emittierbaren Lichts wird durch den Träger 102 emittiert.

Es ist jedoch anwendungsspezifisch nicht erforderlich, dass jede Leiterbahn der Leiterstruktur 406 mit einem lichtemittierenden Bauelement 108 verbunden ist (veranschaulicht in FIG.5). Beispielsweise kann eine Leiterbahn, die nicht direkt mit einem lichtemittierenden Bauelement 108 verbunden ist (in FIG. 2 die rechts veranschaulichte Leiterbahn), dazu verwendet werden, unterschiedliche elektrische Verschaltungen der lichtemittierenden Bauelemente 108 zu realisieren.

Die mehreren lichtemittierenden Bauelemente 108 können gleich oder unterschiedlich zueinander eingerichtet sein. Beispielsweise können die lichtemittierenden Bauelemente 108 Licht unterschiedlicher Farbe emittieren bzw. dementsprechend eingerichtet sein.

Die somit ausgebildete Vorrichtung 200 mit mindestens einem lichtemittierenden Bauelement 108 weist auf: eine Aufwachsschicht 404 auf einem Träger 102, eine mindestens teilweise galvanisch abgeschiedene Leiterstruktur 406 direkt auf der Aufwachsschicht 404; und mindestens ein lichtemittierendes Bauelement (108) auf oder über der Leiterstruktur 406 und mit dieser elektrisch leitend verbunden.

Im Rahmen dieser Beschreibung kann ein lichtemittierendes Bauelement 108 ein Halbleiterbauelement sein, welches elektromagnetische Strahlung bereitstellt, beispielsweise in Form einer bedrahteten Leuchtdiode, einer aufliegenden Leuchtdiode (surface mounted device - SMD) oder einer chip-on-board Leuchtdiode (Die).

Im Rahmen dieser Beschreibung kann ein Halbleiterchip, der elektromagnetische Strahlung bereitstellen kann, als LED-Chip verstanden werden.

Ein lichtemittierendes Bauelement 108 kann beispielsweise einen Halbleiterchip der elektromagnetische Strahlung bereitstellt aufweisen (bedrahtete LED, SMD, beispielsweise eine gepackaged LED.) oder als ein Halbleiterchip der elektromagnetische Strahlung bereitstellt eingerichtet sein (chip-on-board).

In verschiedenen Ausführungsbeispielen ist das lichtemittierende Bauelement 108 ein Halbleiterchip in Form eines Flip-Chips, bei dem mindestens zwei Kontakte auf der Rückseite des Halbleiterchips ausgebildet sind (und dem Träger 102 zugewandt werden). Eine elektrische Kontaktierung kann ohne wire bonding erfolgen, beispielsweise mittels Lot-Kugeln (engl. solder balls), beispielsweise in einem Reflow-Prozess.

Auf oder über dem Halbleiterchip kann eine Verpackung (Package) aufgebracht und/oder ausgebildet sein. Die Verpackung kann beispielsweise, als Verkapselung, optische Linse und/oder als Konverterelement ausgebildet sein.

Eine bedrahtete Leuchtdiode kann einen Halbleiterchip aufweisen, der elektromagnetische Strahlung bereitstellen kann, beispielsweise einen LED-Chip. Der Halbleiterchip kann beispielsweise mit einer Kunststoffkappe verkapselt sein. Die Kunststoffkappe kann den LED Chip während der Fertigung und im Betrieb vor äußeren, schädlichen Einflüssen, beispielsweise Sauerstoff und/oder Wasser, schützen.

Eine aufliegende Leuchtdiode (SMD) kann einen LED-Chip in einem Gehäuse aufweisen. Das Gehäuse kann mit einem Substrat schlüssig fixiert sein.

Eine chip-on-board-Leuchtdiode kann einen LED-Chip aufweisen, der auf einem Substrat fixiert ist, wobei der LED-Chip weder ein Gehäuse noch Kontaktpads aufweisen kann.

Die einzelnen Halbleiterchips können beispielsweise auf einem Substrat, beispielsweise einer Leiterplatine aufgebracht bzw. ausgebildet werden.

Die Halbleiterchips können mittels Kontaktpads mit der Leiterplatine verdrahtet sein (wire bonding). Die Verdrahtungen kann beispielsweise mittels Gold-Drähten erfolgen.

In verschiedenen Ausführungsbeispielen ist das lichtemittierende Bauelement 108 als eine Laserdiode eingerichtet.

In verschiedenen Ausführungsbeispielen ist das lichtemittierende Bauelement 108 ein Halbleiterchip, bei dem ein Kontakt auf Rückseite des Halbleiterchips ausgebildet ist und ein Kontakt auf der Vorderseite des Halbleiterchip. Der Halbleiterchip kann mittels eines Drahtes elektrisch kontaktiert werden (engl. wire bonding).

In verschiedenen Ausführungsbeispielen wird das mindestens eine lichtemittierende Bauelement 108 mittels eines schlüssigen Verbindungsverfahrens auf oder über der Leiterstruktur angeordnet, beispielsweise mittels eines Reflow-Prozesses eines Lot bzw. von Lot-Kugeln, die zwischen lichtemittierendem Bauelement 108 und Leiterstruktur 406 angeordnet sind.

Die elektrische Anbindung des lichtemittierenden Bauelementes mit einer oder mehreren Leiterbahnen der Leiterstruktur 406 kann alternativ oder zusätzlich mittels Verklebens mittels eines elektrisch leitfähigen Klebstoffes (anisotropic conductive film bonding - ACF-Bonden), eines Reibschweißprozesses (Ultraschall-Bonden) oder ähnlichem, erfolgen.

Ein Anschluss bzw. mehrere Anschlüsse des lichtemittierenden Bauelements 108 kann/können beispielsweise mit einem oder mehreren Kontaktpad(s) der Leiterstruktur 406 elektrisch leitend verbunden werden. Das lichtemittierende Bauelement 108 kann beispielsweise durch die Leiterstruktur 406 von einer externen Stromquelle bestromt werden. Die elektrische Verbindung des elektrischen Anschlusses mit einem Kontaktpad und/oder einer Leiterbahn der Leiterstruktur 406 wird beispielsweise mittels einer Lötverbindung an einer Lötstelle mechanisch gesichert.

In verschiedenen Ausführungsformen, die nicht zur Erfindung gehören, wird die Aufwachsschicht 404 auf den Träger 102 mittels eines Klebstoffes aufgeklebt bzw. auflaminiert. Die Schicht aus Klebstoff kann auch als Haftmittelschicht bezeichnet werden.

Der Klebstoff, das Halbleiterbauelement und/oder der Träger der in FIG.4 und FIG.5 veranschaulichten Ausführungsform können/kann insbesondere gemäß einer oben beschriebenen Ausführungsform eingerichtet sein.

### Bezugszeichenliste

- 100, 120, 140, 400, 420, 440, 460: Verfahrensschritte
- 102: Träger
- 104, 114, 124, 412, 414, 416: Leiterbahnen
- 106: reflektierende Beschichtung
- 108: lichtemittierendes Bauelement
- 110: Lichtemissionsrichtung
- 130: Kontaktpad
- 132: freiliegender Teil eines Kontaktpads
- 200: lichtemittierende Vorrichtung
- 300: Stempel
- 302: temporäres Substrat
- 304: lösbare Beschichtung
- 306: Klebstoffschicht
- 404: Aufwachsschicht
- 406: Leiterstruktur

## Patentansprüche

1. Verfahren zum Herstellen einer lichtemittierenden Vorrichtung, das Verfahren aufweisend:
Ausbilden eines Trägers (102) mit mindestens einer Leiterbahn (104, 114, 124) auf einer Oberfläche des Trägers (102);
Ausbilden einer reflektierenden Beschichtung (106) direkt auf der mindestens einen Leiterbahn (104, 114, 124) mittels eines Folientransfer-Verfahrens derart, dass die Leiterbahn (104, 114, 124) im Wesentlichen von der reflektierenden Beschichtung (106) bedeckt ist; und Anordnen eines lichtemittierenden Bauelementes (108) auf oder über der reflektierenden Beschichtung (106), wobei das lichtemittierende Bauelement (108) elektrisch leitend mit der mindestens einen Leiterbahn (104, 114, 124) verbunden wird,
wobei auf der Oberfläche des Trägers (102) ferner mindestens ein Kontaktpad (130) ausgebildet ist, das elektrisch leitend mit der mindestens einen Leiterbahn (104, 114, 124) verbunden ist, und
wobei die reflektierende Beschichtung (106) derart auf oder über dem Kontaktpad (130) ausgebildet wird, dass mindestens ein Teil (132) des Kontaktpads (130) freiliegt.

2. Verfahren nach Anspruch 1,
wobei die reflektierende Beschichtung (106) ferner als eine Lötstopp-Struktur für das Kontaktpad (130) ausgebildet wird.

3. Verfahren nach Anspruch 2,
wobei das lichtemittierende Bauelement (108) durch das Kontaktpad (130) elektrisch leitend mit der mindestens einen Leiterbahn (104, 114, 124) verbunden wird.

4. Verfahren nach einem der Ansprüche 2 oder 3,
wobei eine Lötverbindung zwischen dem lichtemittierenden Bauelement und dem Kontaktpad (130) ausgebildet wird.

5. Verfahren nach einem der Ansprüche 1 bis 4,
wobei der Träger (102) mindestens eine erste Leiterbahn (104, 114, 124) und eine von der ersten Leiterbahn (104, 114, 124) elektrisch isolierte zweite Leiterbahn (104, 114, 124) aufweist, und die reflektierende Beschichtung (106) einen ersten Abschnitt aufweist, der direkt auf der ersten Leiterbahn (104, 114, 124) ausgebildet wird, und einen zweiten Abschnitt aufweist, der direkt auf der zweiten Leiterbahn (104, 114, 124) ausgebildet wird, wobei der erste Abschnitt elektrisch isoliert ist von dem zweiten Abschnitt.

6. Verfahren nach einem der Ansprüche 1 bis 5,
wobei die reflektierende Beschichtung (106) elektrisch leitend ausgebildet wird, insbesondere ein elektrisch leitendes Material aufweist.

7. Verfahren nach einem der Ansprüche 1 bis 5,
wobei die reflektierende Beschichtung (106) elektrisch nicht-leitend ausgebildet wird, insbesondere ein elektrisch nicht-leitendes Material aufweist.

8. Verfahren nach einem der Ansprüche 1 bis 7,
wobei die reflektierende Beschichtung (106) mittels eines kalten Folientransfer-Verfahrens auf oder über dem Träger (102) aufgebracht wird.

9. Verfahren nach einem der Ansprüche 1 bis 7,
wobei die reflektierende Beschichtung (106) mittels eines heißen Folientransfer-Verfahrens auf oder über dem Träger (102) aufgebracht wird.

## Claims

1. Method for manufacturing a light emitting device, the method comprising:
forming a substrate (102) having at least one conductive path (104, 114, 124) on a surface of the substrate (102);
forming a reflective coating (106) directly on the at least one conductive path (104, 114, 124) by a foil transfer process such that the conductive path (104, 114, 124) is substantially covered by the reflective coating (106); and
arranging a light-emitting component (108) on or over the reflective coating (106), wherein the light-emitting component (108) is electrically conductively connected to the at least one conductive path (104, 114, 124),
wherein on the surface of the substrate (102) further at least one contact pad (130) is formed electrically conductively connected to the at least one conductive path (104, 114, 124), and
wherein the reflective coating (106) is formed on or over the contact pad (130) such that at least a portion (132) of the contact pad (130) is exposed.

2. Method according to claim 1,
wherein the reflective coating (106) is further formed as a solder stop structure for the contact pad (130).

3. Method according to claim 2,
wherein the light-emitting component (108) is electrically conductively connected to the at least one conductive path (104, 114, 124) by the contact pad (130).

4. Method according to any one of claims 2 or 3,
wherein a solder connection is formed between the light-emitting component and the contact pad (130).

5. Method according to any one of claims 1 to 4,
wherein the substrate (102) comprises at least a first conductive path (104, 114, 124) and a second conductive path (104, 114, 124) electrically insulated from the first conductive path (104, 114, 124), and the reflective coating (106) comprises a first portion formed directly on the first conductive path (104, 114, 124) and a second portion formed directly on the second conductive path (104, 114, 124), the first portion being electrically insulated from the second portion.

6. Method according to any one of claims 1 to 5,
wherein the reflective coating (106) is formed electrically conductive, in particular comprises an electrically conductive material.

7. Method according to any one of claims 1 to 5,
wherein the reflective coating (106) is formed electrically non-conductive, in particular comprises an electrically non-conductive material.

8. Method according to any one of claims 1 to 7,
wherein the reflective coating (106) is applied to or over the substrate (102) by means of a cold foil transfer process.

9. Method according to any one of claims 1 to 7,
wherein the reflective coating (106) is applied to or over the substrate (102) by means of a hot foil transfer process.

## Revendications

1. Procédé de fabrication d'un dispositif émetteur de lumière, le procédé comprenant :
former un support (102) avec au moins une piste conductrice (104, 114, 124) sur une surface du support (102);
former un revêtement réfléchissant (106) directement sur ladite au moins une piste conductrice (104, 114, 124) par un procédé de transfert de film de telle sorte que ladite piste conductrice (104, 114, 124) soit sensiblement recouverte par ledit revêtement réfléchissant (106); et
disposer un composant émetteur de lumière (108) sur ou au-dessus du revêtement réfléchissant (106), le composant émetteur de lumière (108) étant relié de manière électriquement conductrice à la au moins une piste conductrice (104, 114, 124),
au moins un plot de contact (130) étant en outre formé sur la surface du support (102), lequel est relié de manière électriquement conductrice à l'au moins une piste conductrice (104, 114, 124), et
dans lequel le revêtement réfléchissant (106) est formé sur ou au-dessus du plot de contact (130) de telle sorte qu'au moins une partie (132) du plot de contact (130) est exposée.

2. Procédé selon la revendication 1,
dans lequel le revêtement réfléchissant (106) est en outre formé comme une structure d'arrêt de soudure pour le plot de contact (130).

3. Procédé selon la revendication 2,
dans lequel le composant émetteur de lumière (108) est connecté électriquement à l'au moins une piste conductrice (104, 114, 124) par le plot de contact (130).

4. Procédé selon l'une des revendications 2 ou 3,
dans lequel une connexion soudée est formée entre le composant électroluminescent et le plot de contact (130).

5. Procédé selon l'une quelconque des revendications 1 à 4,
dans lequel le support (102) comprend au moins une première piste conductrice (104, 114, 124) et une deuxième piste conductrice (104, 114, 124) isolée électriquement de la première piste conductrice (104, 114, 124), et le revêtement réfléchissant (106) comprend une première partie formée directement sur la première piste conductrice (104, 114, 124) et une deuxième partie formée directement sur la deuxième piste conductrice (104, 114, 124), la première partie étant isolée électriquement de la deuxième partie.

6. Procédé selon l'une quelconque des revendications 1 à 5,
dans lequel le revêtement réfléchissant (106) est formé de manière à être électriquement conducteur, en particulier comprend un matériau électriquement conducteur.

7. Procédé selon l'une quelconque des revendications 1 à 5,
dans lequel le revêtement réfléchissant (106) est réalisé de manière non conductrice de l'électricité, notamment en présentant un matériau non conducteur de l'électricité.

8. Procédé selon l'une quelconque des revendications 1 à 7,
dans lequel le revêtement réfléchissant (106) est appliqué sur ou au-dessus du support (102) par un procédé de transfert de film à froid.

9. Procédé selon l'une quelconque des revendications 1 à 7,
dans lequel le revêtement réfléchissant (106) est appliqué sur ou au-dessus du support (102) par un procédé de transfert de film à chaud.
